# EUROPÄISCHE PATENTSCHRIFT

(11) **EP 0 838 089 B1**
(45) Veröffentlichungstag und Bekanntmachung des Hinweises auf die Patenterteilung: **19.09.2001**
(21) Anmeldenummer: 96918603.0
(22) Anmeldetag: 24.06.1996
(51) Int. Cl.: H01L 21/8242, H01L 27/108, H01L 21/763, H01L 21/308

(54) **INTEGRIERTE SCHALTUNGSANORDNUNG MIT MINDESTENS ZWEI GEGENEINANDER ISOLIERTEN BAUELEMENTEN UND VERFAHREN ZU DEREN HERSTELLUNG**
INTEGRATED CIRCUIT ARRANGEMENT WITH AT LEAST TWO COMPONENTS INSULATED FROM ONE ANOTHER AND A PROCESS FOR PRODUCING THE SAID CIRCUIT ARRANGEMENT
CIRCUIT INTEGRE COMPORTANT AU MOINS DEUX COMPOSANTS ISOLES L'UN PAR RAPPORT A L'AUTRE, ET PROCEDE DE FABRICATION DUDIT CIRCUIT

(30) Priorität: 10.07.1995 DE 19525072
(43) Veröffentlichungstag der Anmeldung: 29.04.1998
(73) Patentinhaber: Infineon Technologies AG, 81669 München (DE)
(72) Erfinder: LAU, Frank, D-83052 Bruckmühl (DE); KRAUTSCHNEIDER, Wolfgang, D-83104 Hohenthann (DE); ENGELHARDT, Manfred, D-83620 Feldkirchen-Westerham (DE)
(74) Vertreter: Zedlitz, Peter, Dipl.-Inf.
(86) Internationale Anmeldenummer: DE9601109
(87) Internationale Veröffentlichungsnummer: WO9703463

(56) Entgegenhaltungen:
- DE-A- 3 809 218
- US-A- 4 835 584
- US-A- 5 122 848
- US-A- 5 512 517

## Beschreibung

Integrierte Schaltungsanordnung mit mindestens zwei gegeneinander isolierten Bauelementen und Verfahren zu deren Herstellung.

In der Halbleitertechnologie, speziell der MOS-Technologie werden Grabenisolationen verwendet, um bei einer kleinen Breite eines Isolationsgebietes Bauelemente in einem Substrat elektrisch voneinander zu trennen. Als Grabenisolation wird meist ein Längsgraben verwendet, der vollständig mit SiO₂ aufgefüllt ist. Die Tiefe des Grabens entspricht meist ungefähr der kleinsten Strukturabmessung in der jeweiligen Technologie.

Durch die Grabenisolation werden Leckströme im Volumen unterbunden. Sind an der Oberfläche des Grabens isolierende Schichten und leitfähige Schichten angeordnet, so kann es an der Oberfläche zu Leckströmen aufgrund von parasitären MOS-Bauelementen kommen. Auch diese Leckströme müssen durch die Grabenisolation unterbunden werden.

Zur Verbesserung des Isolationsverhaltens der Grabenisolationen werden im Bereich der Grabenisolation dotierte Gebiete eingesetzt, die die Ausbildung leitender Kanäle verhindern. Diese dotierten Gebiete werden in der Regel durch Implantation erzeugt. Diese Implantation beeinflußt jedoch die Parameter der Bauelemente, die voneinander isoliert werden.

Ferner ist vorgeschlagen worden, den Querschnitt des Grabens im Bodenabschnittsbereich des Grabens zu vergrößern. Die zu isolierenden Bauelemente sind an der Oberfläche des Substrats angeordnet (siehe DE 38 09 218 A1).

Der Erfindung liegt daher das Problem zugrunde, eine integrierte Schaltungsanordnung anzugeben, in der mindestens zwei Bauelemente auf platzsparende Weise gegeneinander isoliert sind und eine Beeinträchtigung der Eigenschaften der Bauelemente durch für die Isolation erforderliche Implantationen vermieden wird. Darüber hinaus soll ein Verfahren zur Herstellung einer solchen integrierten Schaltungsanordnung angegeben werden.

Dieses Problem wird erfindungsgemäß gelöst durch eine integrierte Schaltungsanordnung gemäß Anspruch 1 sowie ein Verfahren gemäß Anspruch 3. Weitere Ausgestaltungen der Erfindung gehen aus den Unteransprüchen hervor.

Die erfindungsgemäße integrierte Schaltungsanordnung ist in einem Halbleitersubstrat integriert. Das Halbleitersubstrat besteht vorzugsweise aus monokristallinem Silizium oder in der monokristallinen Siliziumschicht eines SOI-Substrates.

In dem Halbleitersubstrat ist ein Graben angeordnet, der von einer Hauptfläche des Halbleitersubstrats in das Halbleitersubstrat hineinreicht. Mindestens eine Flanke des Grabens ist mit einer Isolationsstruktur versehen, die ein erstes Bauelement gegen ein zweites Bauelement isoliert. Die mit der Isolationsstruktur versehene Flanke des Grabens weist eine Ausbuchtung auf, so daß die Weite des Grabens im Bereich des Grabenbodens größer ist als im Bereich der Hauptfläche.

Das erste Bauelement ist an der Hauptfläche und das zweite Bauelement am Grabenboden angeordnet. Die Isolationsstruktur bedeckt die zwischen den beiden Bauelementen angeordnete Flanke. Die erhöhte Dicke der Isolationsstruktur im Bereich der Ausbuchtung stellt sicher, daß ein entlang der Flanke gegebenenfalls entstehendes parasitäres MOS-Bauelement eine so hohe Schwellenspannung hat, daß bei den Betriebsspannungen keine Leckströme an der Oberfläche der Flanke auftreten.

Die Isolationsstruktur reicht von der Hauptfläche bis zum Grabenboden. Die Dicke der Isolationsstruktur, das heißt die Ausdehnung der Isolationsstruktur senkrecht zu der Flanke, ist dabei im Bereich der Ausbuchtung größer als an der Hauptfläche. Die laterale Ausdehnung der erfindungsgemäßen Isolationsstruktur ist im Substrat größer als an der Hauptfläche des Substrats. Dadurch wird die Isolationswirkung der Isolationsstruktur verbessert gegenüber dem Wert, der mit einer Isolationsstruktur, die über die gesamte Tiefe die konstante, laterale Ausdehnung an der Hauptfläche aufweist, erzielt würde.

Da die Isolationsstruktur an der Flanke des Grabens angeordnet ist, können das erste Bauelement und das zweite Bauelement in der Projektion auf die Hauptfläche unmittelbar nebeneinander angeordnet werden. Da das erste Bauelement an der Hauptfläche und das zweite Bauelement am Grabenboden angeordnet sind und zwischen ihnen an der Grabenflanke die Isolationsstruktur angeordnet ist, sind sie gegeneinander isoliert. Das Sperrverhalten der Isolationsstruktur ist dabei insbesondere über deren Dicke im Bereich der Ausbuchtung einstellbar.

Die Erfindung ist vorteilhaft einsetzbar zum Aufbau einer Speicherzellenanordnung. Dazu umfaßt die integrierte Schaltungsanordnung mehrere gleichartige streifenförmige Gräben, die im wesentlichen parallel verlaufen. Die Flanken der Gräben weisen jeweils im Bereich des Grabenbodens Ausbuchtungen auf und sind jeweils mit einer Isolationsstruktur versehen. An der Hauptfläche zwischen benachbarten Gräben und an den Grabenböden sind jeweils mehrere, in Reihe verschaltete MOS-Transistoren der Speicherzellenanordnung angeordnet. Durch Einsatz selbstjustierender Herstellverfahren läßt sich eine solche Speicherzellenanordnung mit einem Flächenbedarf pro Speicherzelle von 2F², wobei F die in der jeweiligen Technologie minimale Strukturgröße ist, herstellen.

Zur Herstellung der erfindungsgemäßen Schaltungsstruktur wird in der Hauptfläche des Substrats ein Graben erzeugt, der im Bereich des Grabenbodens eine größere Weite als an der Hauptfläche aufweist. Die Ausbuchtungen in der Flanke des Grabens können auf verschiedene Weise erzeugt werden. Zum einen wird der Graben durch Plasmaätzen erzeugt, wobei die Ätzung in einem solchen Parameterbereich durchgeführt wird, daß der sogenannte "Barrelling Effekt" (auch "Bowing" genannt) auftritt. Man versteht darunter eine Ausbuchtung im unteren Bereich der Grabenprofile, die beim Plasmaätzen von Silizium bei einer Überhöhung des Druckes über denjenigen Druck, bei dem eine anisotrope Ätzung realisiert wird, auftritt. Der Barrelling-Effekt (bzw. Bowing) ist zum Beispiel aus M. Engelhardt, S. Schwarzl, J. Electrochem. Soc., Bd. 134, Seite 1985 (1987) und VLSI Electronics Microstrukture Science, Volume 8, Plasma Prcoessing for VLSI N. G. Einspruch and D. M. Brown, Chapter 5, Academic Press Inc., Orlando, 1984, Seite 124 ff, bekannt. Ebenso wird dieser Effekt (auch "Bowing" genannt) beobachtbar bei einer Verringerung der RF-Leistung unter diejenige RF-Leistung, bei der eine anisotrope Ätzung realisiert wird. Alternative Prozesse zum Erzeugen von Barrling/Bowing beim Si-Ätzen sind HBr, O₂, NF₃, mit RF-Leistung < 500 W oder CBrF₃ mit RF-Leistung < 50 W.

Zum anderen kann das Grabenprofil durch eine Kombination von anisotropen und isotropen Ätzprozessen realisiert werden. Vorzugsweise wird in einem ersten Ätzschritt ein anisotropes Plasmaätzverfahren und in einem zweiten Ätzschritt ein isotropes Plasmaätzverfahren oder eine isotrope Naßätzung durchgeführt. Anisotrope Plasmaätzverfahren können so geführt werden, daß es an den Seitenwänden des entstehenden Grabens zur Ablagerung von Ätzprodukten, die als Seitenwandpassivierungen bezeichnet werden, kommt. Beim Ätzen eines Grabens im Silizium bestehen diese Seitenwandpassivierungen aus oxidartigen Verbindungen. Die Dicke der Seitenwandpassivierung nimmt zum Grabenboden hin ab. Dadurch wird in dem isotropen, zweiten Ätzschritt der obere Bereich der Flanke des Grabens vor dem Ätzangriff geschützt und die Ausbuchtung entsteht lediglich im Bereich des Grabenbodens.

Zur Bildung der Isolationsstruktur wird der Graben vorzugsweise mit einer ersten isolierenden Schicht aufgefüllt. Durch anisotropes Ätzen selektiv zu dem Substratmaterial wird die erste isolierende Schicht rückgeätzt. Dabei verbleibt in den Ausbuchtungen des Grabens ein Ätzresiduum aus isolierendem Material. Es füllt die Ausbuchtung im wesentlichen auf. Durch Abscheiden und anisotropes Rückätzen einer zweiten isolierenden Schicht mit im wesentlichen konformer Kantenbedeckung werden an den Flanken des Grabens isolierende Spacer erzeugt, die gemeinsam mit dem in der Ausbuchtung angeordneten Ätzresiduum jeweils die Isolationsstruktur bilden. Auf diese Weise wird die Isolationsstruktur selbstjustiert zum Graben, das heißt ohne Einsatz einer zum Graben zu justierenden Maske, gebildet. Der Graben kann mit einer minimalen Weite von F (F: minimale Strukturbreite in der jeweiligen Technologie) gebildet werden. Die laterale Ausdehnung der Isolationsstruktur wird bestimmt durch die Tiefe der Ausbuchtung senkrecht zur Flanke des Grabens und durch die Schichtdicke der zweiten isolierenden Schicht, aus der die Spacer gebildet werden. Vorzugsweise wird die Ausbuchtung mit einem Radius < F/4 ausgeführt. Die Breite des Spacers wird vorzugsweise ebenfalls < F/4 ausgeführt. Damit wird die Isolationsspannung zwischen einem Bauelement an der Hauptfläche und einem Bauelement am Grabenboden um etwa einen Faktor 2 gegenüber dem Wert erhöht, der sich bei alleiniger Verwendung des Spacers als Isolationsstruktur ergeben würde.

Im weiteren wird die Erfindung anhand der Figuren und der Ausführungsbeispiele näher erläutert.
- Figur 1: zeigt ein Substrat mit einem Graben, dessen Flanken im Bereich des Grabenbodens Ausbuchtungen aufweisen.
- Figur 2: zeigt das Substrat nach Auffüllung des Grabens mit einer ersten isolierenden Schicht.
- Figur 3: zeigt das Substrat nach Rückätzen der ersten isolierenden Schicht, wobei in den Ausbuchtungen Ätzresiduen verbleiben.
- Figur 4: zeigt das Substrat nach Bildung von isolierenden Spacern.
- Figur 5: bis Figur 10 zeigt Schritte bei der Herstellung einer Speicherzellenanordnung.

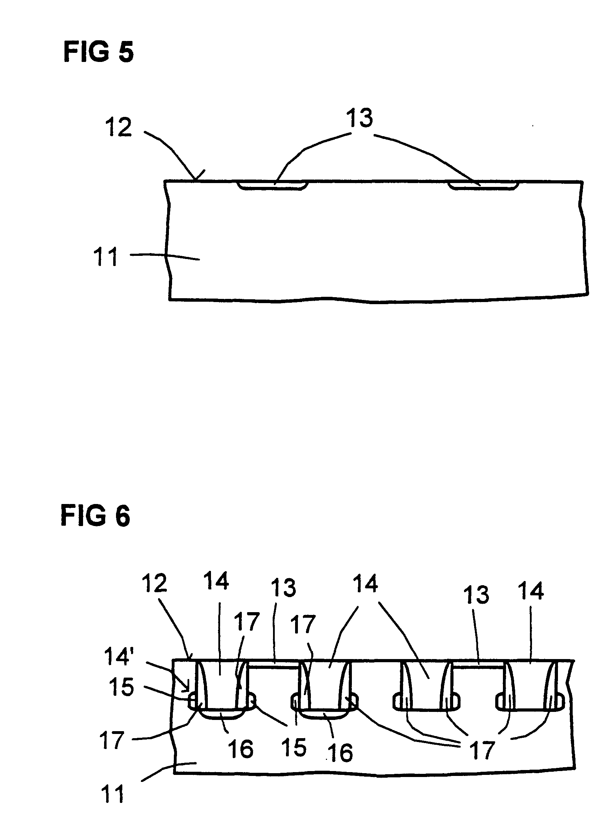

- Figur 5: zeigt ein Substrat nach einer ersten Kanalimplantation.
- Figur 6: zeigt das Substrat nach einer Grabenätzung, einer zweiten Kanalimplantation und der Bildung von Isolationsstrukturen.

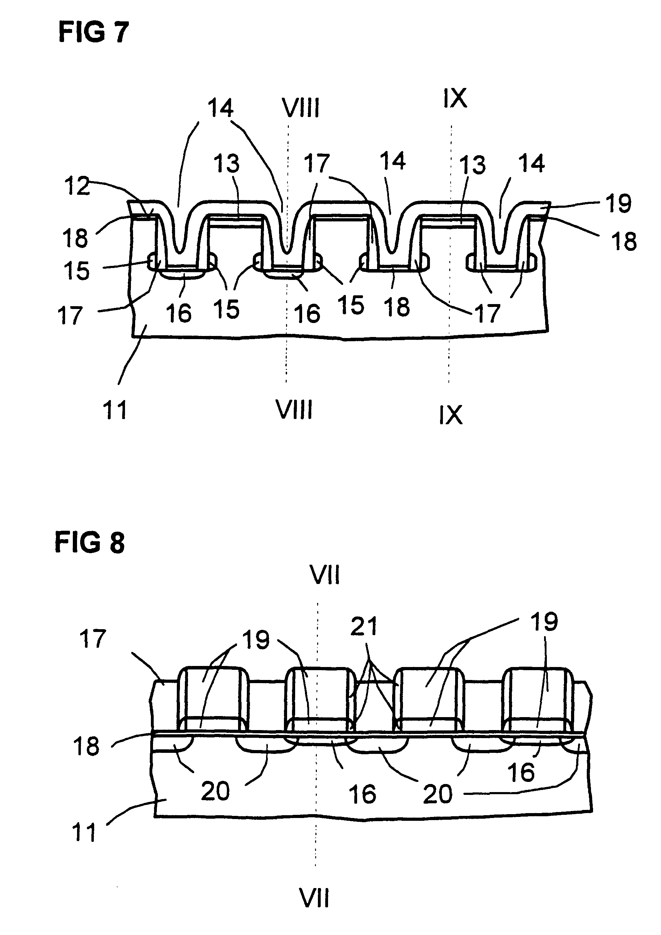

- Figur 7: zeigt das Substrat nach Bildung von Wortleitungen.
- Figur 8: zeigt den in Figur 7 mit VIII-VIII bezeichneten Schnitt durch das Siliziumsubstrat.

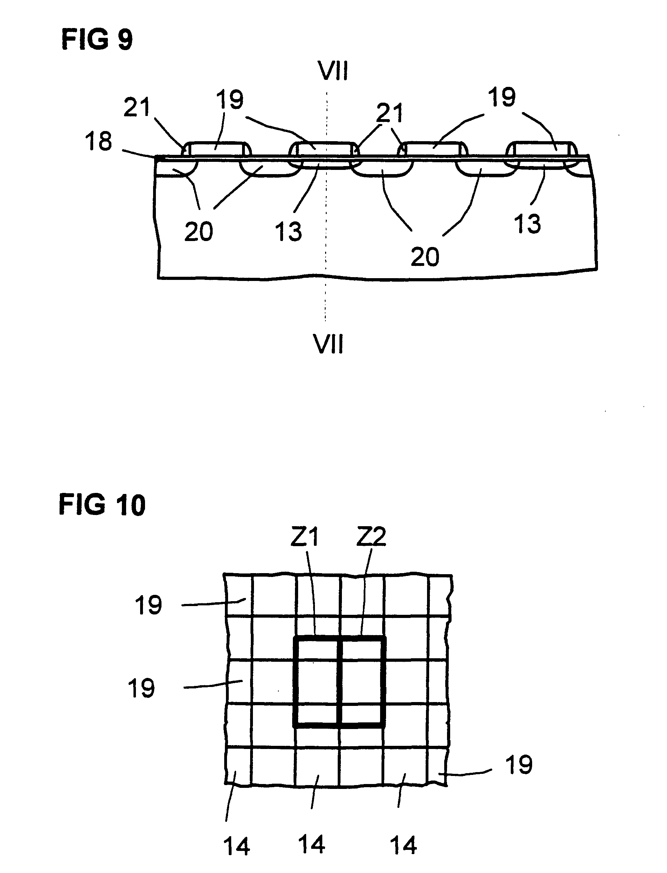

- Figur 9: zeigt den in Figur 7 mit IX-IX bezeichneten Schnitt durch das Siliziumsubstrat.
- Figur 10: zeigt eine Aufsicht auf das in Figur 7 dargestellte Siliziumsubstrat.

Die Darstellungen in den Figuren sind nicht maßstäblich.

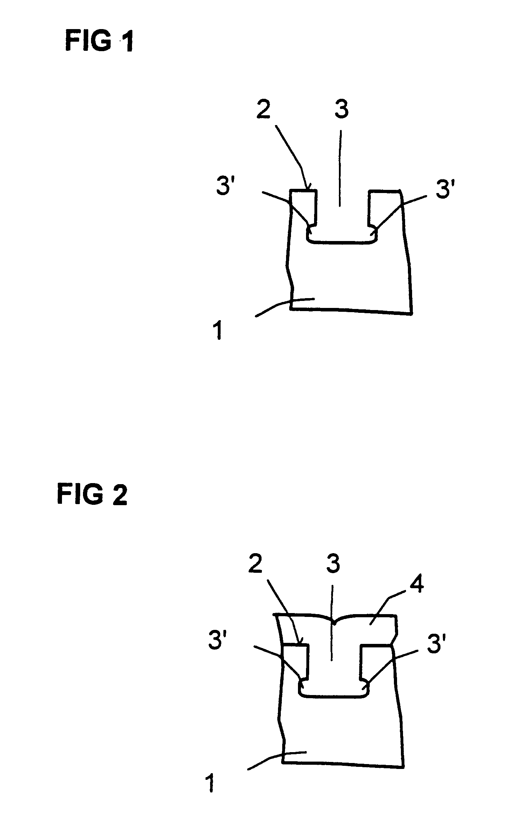

Ein Substrat 1 aus zum Beispiel monokristallinem Silizium weist eine Hauptfläche 2 auf. Auf die Hauptfläche 2 wird eine Grabenmaske aus zum Beispiel TEOS (nicht dargestellt) aufgebracht. Unter Verwendung der Grabenmaske als Ätzmaske wird ein Graben 3 in das Substrat 1 geätzt (siehe Figur 1). Der Graben 3 weist senkrecht zur Hauptfläche 2 eine Ausdehnung von zum Beispiel F auf. Im Bereich des Grabenbodens weist der Graben 3 Ausbuchtungen 3' auf. Dadurch ist die Weite des Grabens 3 im Bereich des Grabenbodens größer als an der Hauptfläche 2. An der Hauptfläche 2 weist der Graben 3 eine Weite von zum Beispiel F, auf. Die maximale Weite im Bereich der Ausbuchtungen3' beträgt dagegen F + 2 F/4. F ist die in der jeweiligen Technologie kleinste herstellbare Strukturgröße. F ist beispielsweise 0,4 µm.

Der Graben 3 mit den Ausbuchtungen 3' wird zum Beispiel durch Plasmaätzen mit CBrF₃ im Druckbereich > 15 mTorr oder mit HBr, O₂, NF₃ im Druckbereich > 100 mTorr erzeugt. Bei diesem Druck entstehen die Ausbuchtungen 3' durch den Barrelling Effekt.

Alternativ wird der Graben 3 durch die Kombination aus einem anisotropen Plasmaätzverfahren mit HBr, O₂, NF₃ im Druckbereich > 100 mTorr oder mit CBrF₃ im Druckbereich > 15 mTorr und einem isotropen Plasmaätzverfahren mit NF₃ im Druckbereich von > 500 mTorr erzeugt. Bei dem isotropen Plasmaätzverfahren entstehen die Ausbuchtungen 3'. Bei dem anisotropen Plasmaätzverfahren an den Flanken des Grabens 3 abgeschiedene Seitenwandpassivierungen schützen den oberen Bereich des Grabens 3 bei der isotropen Plasmaätzung.

Eine weitere Möglichkeit zur Bildung des Grabens 3 mit den Ausbuchtungen 3' besteht in der Kombination aus einem anisotropen Plasmaätzverfahren mit zum Beispiel HBr, O₂, NF₃ im Druckbereich > 100 mTorr oder mit CBrF₃ im Druckbereich > 15 mTorr und einer isotropen naßchemischen Ätzung, zum Beispiel mit Cholin in wäßriger Lösung oder KOH. Auch in diesem Fall wird der obere Bereich der Grabenflanken durch Seitenwandpassivierungen vor dem isotropen Ätzangriff geschützt. Die isotrope Ätzung führt zur Ausbildung der Ausbuchtungen 3'.

Auf die Hauptfläche 2 wird anschließend eine erste isolierende Schicht aus zum Beispiel SiO₂ aufgebracht. Die erste isolierende Schicht 4 füllt den Graben 3 vollständig aus. Die erste isolierende Schicht 4 wird zum Beispiel in einem CVD-Verfahren in einer Dicke von mindestens F, das heißt 0,4 µm abgeschieden (siehe Figur 2).

Es folgt eine Planarisierung, bei der die Hauptfläche 2 des Substrats 1 freigelegt wird. Die Planarisierung erfolgt zum Beispiel durch plasmaunterstütztes Rückätzen der ersten isolierenden Schicht oder mittels Chemical Mechanical Polishing (CMP).

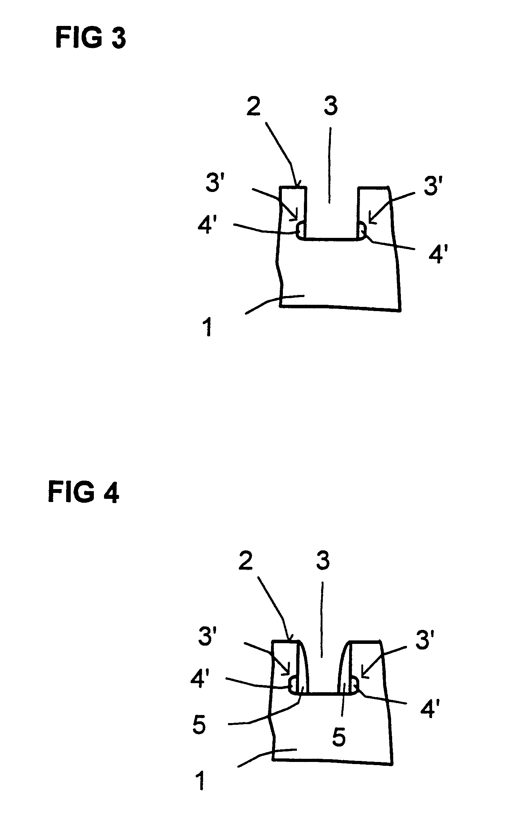

In einem anisotropen Ätzverfahren selektiv zu Silizium wird die verbleibende erste isolierende Schicht 4 rückgeätzt. Dabei wird die Siliziumoberfläche am Grabenboden freigelegt. In den Ausbuchtungen 3' verbleiben Ätzresiduen 4' aus SiO₂. Das Rückätzen erfolgt zum Beispiel mit CHF₃, CF₄, Ar im Druckbereich von 50 bis 500 mTorr (siehe Figur 3).

Es wird eine zweite isolierende Schicht zum Beispiel aus SiO₂ mit im wesentlichen konformer Kantenbedeckung abgeschieden. Die zweite isolierende Schicht wird zum Beispiel in einem TEOS-CVD-Verfahren in einer Dicke von zum Beispiel 40 nm abgeschieden. Durch anisotropes Ätzen zum Beispiel mit CHF₃, CF₄, Ar im Druckbereich von 50 bis 500 mTorr werden aus der zweiten isolierenden Schicht an den Flanken des Grabens 3 isolierende Spacer 5 gebildet. Die Spacer 5 weisen eine Breite von etwa 40 nm auf. Zwischen den Spacern 5 an gegenüberliegenden Flanken des Grabens 3 ist der Grabenboden freigelegt (siehe Figur 4).

Ein erstes Bauelement wird an der Hauptfläche 2, ein zweites Bauelement am Grabenboden erzeugt. Die Bauelemente sind zum Beispiel MOS-Transistoren. Das erste Bauelement ist vom zweiten Bauelement durch die an der dazwischenliegenden Flanke des Grabens 3 angeordnete Isolationsstruktur, die aus dem jeweiligen isolierenden Spacer 5 und dem Ätzresiduum 4' zusammengesetzt ist, isoliert. Ist an der Oberfläche des Spacers 5 eine leitfähige Schicht angeordnet, so entsteht zwischen den beiden Bauelementen ein parasitäres MOS-Element, das wegen der Dicke der Isolationsstruktur im Bereich der Ausbuchtungen 3' eine Schwellenspannung von über 15 Volt aufweist, das heißt weit oberhalb der üblichen Betriebsspannungen für MOS-Transistoren.

Im folgenden wird anhand der Figuren 5 bis 10 die Herstellung einer Festwertspeicherzellenanordnung mit verbesserter vertikaler Isolation erläutert. Die Festwertspeicherzellenanordnung umfaßt als Speicherzellen zum Beispiel MOS-Transistoren, die je nach in der jeweiligen Speicherzelle eingespeicherte Information unterschiedliche Schwellenspannungen aufweisen.

Zur Herstellung der Festwertspeicherzellenanordnung in einem Substrat 11 aus zum Beispiel monokristallinem Silizium wird zunächst an einer Hauptfläche 12 des Substrats 11 eine Isolationsstruktur erzeugt, die den Bereich für die Festwertspeicherzellenanordnung definiert (nicht dargestellt). Das Substrat 11 ist zum Beispiel p-dotiert mit einer Dotierstoffkonzentration von zum Beispiel 10¹⁶ cm⁻³.

Mit Hilfe eines photolithographischen Verfahrens werden dann Bereiche für die Depletion-Kanäle von MOS-Transistoren definiert. Mit Hilfe einer ersten Kanalimplantation mit Arsen mit einer Energie von 50 keV und einer Dosis von 4 x 10¹² cm⁻² werden die Depletion-Kanäle 13 gebildet (siehe Figur 5). Die Ausdehnung der Depletion-Kanäle 13 parallel zur Hauptfläche 12 beträgt bei Verwendung einer 0,4 µm-Technologie zum Beispiel 0,6 µm x 0,6 µm.

Nach Abscheidung einer SiO₂-Schicht in einer Dicke von zum Beispiel 200 nm mit Hilfe eines TEOS-Verfahrens wird durch Strukturierung der SiO₂-Schicht mit Hilfe photolithographischer Verfahren eine Grabenmaske gebildet (nicht dargestellt). Durch anisotropes Ätzen zum Beispiel mit Cl₂ werden unter Verwendung der Grabenmaske als Ätzmaske Längsgräben 14 geätzt. Die Längsgräben 14 weisen eine Tiefe von zum Beispiel 0,6 µm auf. Die Breite der Depletion-Kanäle 13 wird bei der Ätzung der Längsgräben 14 eingestellt. Daher ist die Justierung der Grabenmaske relativ zu den Depletion-Kanälen 13 unkritisch.

Die Weite der Längsgräben 14 beträgt bei einer 0,4 µm-Technologie 0,4 µm, der Abstand benachbarter Längsgräben 14 beträgt ebenfalls 0,4 µm. Die Länge der Längsgräben 14 richtet sich nach der Größe der Speicherzellenanordnung und beträgt zum Beispiel 130 µm.

Im Bereich des Bodens der Längsgräben 14 weisen die Flanken der Längsgräben 14 Ausbuchtungen 14' auf. Diese Ausbuchtungen werden durch eine isotrope Ätzung zum Beispiel mit Cholin in wäßriger Lösung gebildet. Senkrecht zu den Flanken der Längsgräben 14 weisen die Ausbuchtungen 14' eine maximale Tiefe von zum Beispiel 100 nm auf.

Durch eine CVD-Abscheidung einer ersten isolierenden Schicht werden die Längsgräben 14 mit den Ausbuchtungen 14' aufgefüllt. Durch Planarisieren mittels selektivem anisotropen Plasmaätzen oder Chemical Mechanical Polishing (CMP) wird anschließend die Hauptfläche 2 wieder freigelegt. Durch anisotropes Ätzen selektiv zu Silizium mit zum Beispiel CHF₃, CF₄, Ar wird die erste isolierende Schicht rückgeätzt. Dabei wird der Boden der Längsgräben 14 freigelegt. Es verbleiben im Bereich der Ausbuchtungen 14' Ätzresiduen 15 aus SiO₂, die die Ausbuchtungen 14' ausfüllen.

Mit Hilfe eines photolithographischen Verfahrens werden anschließend Bereiche für die Depletion-Kanäle für MOS-Transistoren, die nachfolgend am Boden der Längsgräben 14 hergestellt werden, definiert. Mit einer zweiten Kanalimplantation mit zum Beispiel Arsen und einer Energie von zum Beispiel 50 keV und einer Dosis von zum Beispiel 4 x 10¹² cm⁻² werden die Depletion-Kanäle 16 am Boden der Längsgräben 14 erzeugt (siehe Figur 6). Die Bereiche zwischen benachbarten Längsgräben 6 sind dabei durch die Grabenmaske maskiert. Die Justierung bei der Definition der Depletion-Kanäle 16 ist daher unkritisch. Bezüglich der Seitenwände der Längsgräben 14 ist die zweite Kanalimplantation selbstjustiert.

Anschließend wird die Grabenmaske naßchemisch zum Beispiel mit NH₄F/HF entfernt. Durch Abscheidung einer weiteren SiO₂-Schicht in einem TEOS-Verfahren und anschließendes anisotropes Ätzen werden an den Seitenwänden der Längsgräben 14 Spacer 17 aus SiO₂ gebildet. Das anisotrope Ätzen erfolgt zum Beispiel mit CHF₃, CF₄, Ar. Die Spacer 17 und die Ätzresiduen 15 bilden gemeinsam die Isolationsstruktur, die benachbarten MOS-Transistoren gegeneinander isoliert.

Nach Aufwachsen und Wegätzen eines Sacrificial-Oxids wird eine Gateoxidschicht 18 in einer Dicke von zum Beispiel 10 nm aufgewachsen. Die Gateoxidschicht 18 ist am Boden der Längsgräben 14 und zwischen den Längsgräben 14 auf der Hauptfläche 12 angeordnet (siehe Figur 7, Figur 8, die den mit VIII-VIII bezeichneten Schnitt durch Figur 7 darstellt, und Figur 9, die den mit IX-IX bezeichneten Schnitt durch Figur 7 darstellt. Der in Figur 7 dargestellte Schnitt ist in Figur 8 und Figur 9 jeweils mit VII-VII bezeichnet).

Es wird ganzflächig eine Polysiliziumschicht in einer Dicke von zum Beispiel 400 nm abgeschieden. Durch Strukturierung der Polysiliziumschicht in einem photolithographischen Prozeßschritt werden Wortleitungen 19 gebildet, die entlang der Hauptfläche 12 zum Beispiel senkrecht zu den Längsgräben 14 verlaufen. Breite und Abstand der Wortleitungen 19 entspricht jeweils einer minimalen Strukturgröße F von zum Beispiel F = 0,4 µm. Die Wortleitungen 19 verlaufen so, daß am Boden der Längsgräben 14 gebildete Depletion-Kanäle 16 jeweils unterhalb einer Wortleitung 19 angeordnet sind.

Anschließend wird eine Source/Drain-Implantation mit zum Beispiel Arsen bei einer Energie von zum Beispiel 25 keV und einer Dosis von zum Beispiel 5 x 10¹⁵ cm⁻² durchgeführt. Bei der Source/Drain-Implantation werden am Boden der Längsgräben 14 sowie in der Hauptfläche 12 zwischen den Längsgräben 14 dotierte Gebiete 20 erzeugt. Die dotierten Gebiete 20 wirken jeweils als gemeinsames Source/Drain-Gebiet für zwei entlang einer Zeile angeordnete, benachbarte MOS-Transistoren. Bei der Source/Drain-Implantation werden gleichzeitig die Wortleitungen 19 dotiert.

Durch Abscheiden und anisotropes Rückätzen einer weiteren SiO₂-Schicht werden die Flanken der Wortleitungen 19 mit Spacern 21 bedeckt. Die Source/Drain-Implantation erfolgt selbstjustiert bezüglich der Wortleitungen 19. Da die dotierten Gebiete 20 vom gleichen Leitfähigkeitstyp wie die Depletion-Kanäle 13, 16 dotiert werden, ist die Justierung bei der Definition der Depletion-Kanäle in der Richtung parallel zum Verlauf der Längsgräben 14 unkritisch. Entsprechend dem Abstand benachbarten Wortleitungen 19, dem Abstand benachbarter Längsgräben 14 sowie den Abmessungen der Längsgräben 14 beträgt die Fläche der dotierten Gebiete 20 parallel zur Hauptfläche 12 maximal F x F, das heißt zum Beispiel 0,4 µm x 0,4 µm.

Je zwei benachbarte dotierte Gebiete 20 und die dazwischen angeordnete Wortleitung 19 bilden jeweils einen MOS-Transistor. Am Boden der Längsgräben 14 sowie zwischen den Längsgräben 14 ist jeweils eine Zeile von in Reihe verschalteten MOS-Transistoren, die jeweils aus zwei dotierten Gebieten 20 und der dazwischen angeordneten Wortleitung 19 gebildet sind, angeordnet. Die am Boden eines Längsgrabens 14 angeordneten MOS-Transistoren sind von den benachbarten, zwischen den Längsgräben 14 angeordneten MOS-Transistoren durch die aus Spacer 17 und Ätzresiduum 15 zusammengesetzte Isolationsstruktur isoliert. Diese Isolationsstruktur weist eine maximale Dicke von etwa 150 nm auf, so daß die Schwellenspannung des an den Flanken der Längsgräben 14 gebildeten, parasitären MOS-Transistors ausreichend hoch ist, um einen Leckstrom zu unterbinden.

Jede Zeile ist am Rand der Festwertspeicherzellenanordnung mit zwei Anschlüssen versehen, zwischen denen die in der Zeile angeordneten MOS-Transistoren in Reihe verschaltet sind (nicht dargestellt). Über diese Anschlüsse können die in der jeweiligen Zeile befindlichen MOS-Transistoren im Sinne einer "NAND"-Architektur angesteuert werden.

Berücksichtigt man, daß jedes der dotierten Gebiete 20 Source/Drain-Gebiet für zwei angrenzende MOS-Transistoren ist, so beträgt die Länge jedes MOS-Transistors parallel zum Verlauf der Längsgräben 14 zwei F. Die Breite der MOS-Transistoren beträgt jeweils F. Herstellungsbedingt beträgt die Fläche für eine aus einem MOS-Transistor gebildete Speicherzelle daher 2 F². Entlang einer Wortleitung 19 benachbarte Speicherzellen, deren Konturen Z1, Z2 in der Aufsicht in Figur 10 als verstärkte Linie eingezeichnet sind, grenzen in der Projektion auf die Hauptfläche 2 unmittelbar aneinander. Die Speicherzelle Z1 ist am Boden eines Längsgrabens 14 angeordnet, die Speicherzelle Z2 dagegen auf der Hauptfläche 12 zwischen zwei benachbarten Längsgräben 14. Durch die Anordnung benachbarter Speicherzellen in zwei in der Höhe versetzte Ebenen wird die Packungsdichte erhöht, ohne daß die Isolation zwischen benachbarten Speicherzellen verschlechtert würde.

Die Programmierung der Festwertspeicherzellenanordnung erfolgt bei der ersten Kanalimplantation und der zweiten Kanalimplantation. Die Depletion-Kanäle 13, 16 werden nur für diejenigen MOS-Transistoren gebildet, denen ein erster logischer Wert zugeordnet wird. Den anderen MOS-Transistoren wird ein zweiter logischer Wert zugeordnet.

Die Festwertspeicherzellenanordnung wird durch Abscheidung eines Zwischenoxids, Kontaktlochätzungen und Aufbringen und Strukturieren einer Metallschicht fertiggestellt. Diese bekannten Prozeßschritte sind nicht dargestellt.

## Patentansprüche

1. Integrierte Schaltungsanordnung,
- bei der ein erstes Bauelement und ein zweites Bauelement in einem Halbleitersubstrat (1) integriert sind,
- bei der in dem Halbleitersubstrat (1) ein Graben (3) angeordnet ist, der von einer Hauptfläche (2) des Halbleitersubstrats (1) in das Halbleitersubstrat (1) hineinreicht und der mit einer Isolationsstruktur (4', 5) versehen ist, die das erste Bauelement gegen das zweite Bauelement isoliert,
- bei der mindestens eine Flanke des Grabens (3) eine Ausbuchtung (3') aufweist, so daß die Weite des Grabens (3) im Bereich des Grabenbodens größer ist als im Bereich der Hauptfläche (2),
- bei der die Isolationsstruktur (4', 5) an die Flanke angrenzt und in zur Hauptfläche (2) senkrechter Richtung von der Hauptfläche (2) bis zum Grabenboden reicht, wobei die Dicke der Isolationsstruktur (4', 5) im Bereich der Ausbuchtung (3') größer ist als an der Hauptfläche (2),
- bei der das erste Bauelement an der Hauptfläche (2) und das zweite Bauelement am Grabenboden angeordnet sind.

2. Integrierte Schaltungsanordnung nach Anspruch 1,
- bei der mehrere gleichartige streifenförmige Gräben (14) vorgesehen sind, die im wesentlichen parallel verlaufen, deren Flanken im Bereich des Grabenbodens Ausbuchtungen (14') aufweisen und deren Flanken jeweils mit einer Isolationsstruktur (14', 17) versehen sind,
- bei der an der Hauptfläche (12) zwischen benachbarten Gräben (14) und an den Grabenböden jeweils mehrere, in Reihe verschaltete MOS-Transistoren einer Speicherzellenanordnung angeordnet sind.

3. Verfahren zur Herstellung einer integrierten Schaltungsanordnung mit mindestens zwei gegeneinander isolierten Bauelementen,
- bei dem in einer Hauptfläche (2) eines Halbleitersubstrats (1) ein Graben (3) erzeugt wird, der in mindestens einer Flanke im Bereich des Grabenbodens eine Ausbuchtung (3') aufweist, in der die Grabenweite größer ist als an der Hauptfläche (2),
- bei dem an der Flanke mit der Ausbuchtung (3') eine Isolationsstruktur (4', 5) erzeugt wird, die sich von der Hauptfläche (2) bis zum Grabenboden erstreckt und die im Bereich der Ausbuchtung (3') dicker als an der Hauptfläche,
- bei dem im Halbleitersubstrat (1) ein erstes Bauelement und ein zweites Bauelement so erzeugt werden, daß sie durch die Isolationsstruktur (4', 5) gegeneinander isoliert sind,
- bei dem das erste Bauelement an der Hauptfläche (2) des Halbleitersubstrats und das zweite Bauelement am Grabenboden erzeugt werden.

4. Verfahren nach Anspruch 3,
bei dem zur Erzeugung des Grabens (3) ein Ätzprozeß mit zwei Ätzschritten durchgeführt wird, wobei in einem ersten Ätzschritt anisotrop geätzt wird und in einem zweiten Ätzschritt isotrop geätzt wird.

5. Verfahren nach Anspruch 4,
bei dem im ersten Ätzschritt ein anisotropes Plasmaätzverfahren und im zweiten Ätzschritt ein isotropes Plasmaätzverfahren oder eine isotrope Naßätzung durchgeführt werden.

6. Verfahren nach einem der Ansprüche 3 bis 5,
- bei dem der Graben (3) als Längsgraben erzeugt wird,
- bei dem zur Bildung der Isolationsstruktur (4', 5) der Graben (3) mit einer ersten isolierenden Schicht (4) aufgefüllt wird.
- bei dem durch anisotropes Ätzen selektiv zu dem Halbleitersubstrat (1) die erste isolierende Schicht (4) rückgeätzt wird, wobei ein Ätzresiduum (4') verbleibt, das die Ausbuchtung (3') im wesentlichen auffüllt,
- bei dem durch Abscheiden und anisotropes Rückätzen einer zweiten isolierenden Schicht mit im wesentlichen konformer Kantenbedeckung mindestens an der Flanke des Grabens (3) ein isolierender Spacer (5) erzeugt wird, der gemeinsam mit dem Ätzresiduum (4') die Isolationsstruktur bildet.

7. Verfahren nach Anspruch 6,
- bei dem mehrere Längsgräben (14) erzeugt werden, die im wesentlichen parallel verlaufen, deren Flanken im Bereich des Grabenbodens Ausbuchtungen (14') aufweisen und deren Flanken jeweils mit einer Isolationsstruktur (15, 17) versehen werden,
- bei dem an der Hauptfläche (12) zwischen benachbarten Längsgräben (14) und an den Grabenböden jeweils mehrere, in Reihe verschaltete MOS-Transistoren einer Speicherzellenanordnung gebildet werden.

## Claims

1. Integrated circuit arrangement,
- in which a first component and a second component are integrated in a semiconductor substrate (1),
- in which a trench (3) is arranged in the semiconductor substrate (1), reaches from a main area (2) of the semiconductor substrate (1) down into the semiconductor substrate (1) and is provided with an insulation structure (4', 5) which insulates the first component from the second component,
- in which at least one side of the trench (3) has a bulge (3'), so that the width of the trench (3) is greater in the region of the trench bottom than in the region of the main area (2),
- in which the insulation structure (4', 5) adjoins the side and reaches, in the direction perpendicular to the main area (2), from the main area (2) down to the trench bottom, the thickness of the insulation structure (4', 5) being greater in the region of the bulge (3') than at the main area (2),
- in which the first component is arranged on the main area (2) and the second component is arranged on the trench bottom.

2. Integrated circuit arrangement according to Claim 1,
- in which there are provided a plurality of identical strip-like trenches (14), which run essentially parallel, whose sides have bulges (14') in the region of the trench bottom and whose sides are each provided with an insulation structure (14', 17),
- in which a plurality of MOS transistors of a memory cell arrangement which are interconnected in series are arranged in each case on the main area (12) between adjacent trenches (14) and on the trench bottoms.

3. Method for the production of an integrated circuit arrangement having at least two mutually insulated components,
- in which a trench (3) is produced in a main area (2) of a semiconductor substrate (1) and has a bulge (3') in at least one side in the region of the trench bottom, in which bulge the trench width is greater than at the main area (2),
- in which an insulation structure (4', 5) is produced on the side with the bulge (3'), which insulation structure extends from the main area (2) down to the trench bottom and is thicker in the region of the bulge (3') than at the main area,
- in which a first component and a second component are produced in the semiconductor substrate (1) in such a way that they are insulated from one another by the insulation structure (4', 5),
- in which the first component is produced on the main area (2) of the semiconductor substrate and the second component is produced on the trench bottom.

4. Method according to Claim 3,
in which an etching process with two etching steps is carried out in order to produce the trench (3), anisotropic etching being carried out in a first etching step and isotropic etching being carried out in a second etching step.

5. Method according to Claim 4,
in which an anisotropic plasma etching process is carried out in the first etching step and an isotropic plasma etching process or isotropic wet etching is carried out in the second etching step.

6. Method according to one of Claims 3 to 5,
- in which the trench (3) is produced as a longitudinal trench,
- in which the trench (3) is filled with a first insulating layer (4) in order to form the insulation structure (4' , 5),
- in which the first insulating layer (4) is etched back by anisotropic etching selectively with respect to the semiconductor substrate (1), an etching residue (4') remaining which essentially fills the bulge (3'),
- in which an insulating spacer (5) is produced at least on the side of the trench (3) by deposition and anisotropic etching back of a second insulating layer having essentially conformal edge covering, which insulating spacer forms the insulation structure together with the etching residue (4').

7. Method according to Claim 6,
- in which a plurality of longitudinal trenches (14) are produced, which run essentially parallel, whose sides have bulges (14') in the region of the trench bottom and whose sides are each provided with an insulation structure (15, 17),
- in which a plurality of MOS transistors of a memory cell arrangement which are interconnected in series are formed in each case on the main area (12) between adjacent longitudinal trenches (14) and on the trench bottoms.

## Revendications

1. Circuit intégré,
- dans lequel un premier composant et un deuxième composant sont intégrés à un substrat (1) semi-conducteur,
- dans lequel il est ménagé dans le substrat (1) semi-conducteur un sillon (3) qui pénètre d'une surface (2) principale du substrat (1) semi-conducteur dans le substrat (1) semi-conducteur et qui est muni d'une structure (4', 5) d'isolement qui isole le premier composant du deuxième composant,
- dans lequel au moins un flanc du sillon (3) comporte une indentation (3'), si bien que la largeur du sillon (3) est plus grande dans la zone du fond du sillon que dans la zone de la surface (2) principale,
- dans lequel la structure (4', 5) d'isolement est adjacente au flanc et va, dans la direction perpendiculaire à la surface (2) principale, de la surface (2) principale jusqu'au fond du sillon, l'épaisseur de la structure (4', 5) d'isolement étant plus grande dans la zone de l'indentation (3') que sur la surface (2) principale,
- dans lequel le premier composant est monté sur la surface (2) principale et le deuxième composant au fond du sillon.

2. Circuit intégré suivant la revendication 1,
- dans lequel il est prévu plusieurs sillons (14) du même genre, en forme de bandes, qui s'étendent sensiblement parallèlement, donc les flancs comportent des indentations (14') dans la zone du fond du sillon et dont le flancs sont munis chaque fois d'une structure (14', 17) d'isolement,
- dans lequel il est disposé sur la surface (12) principale, entre des sillons (14) voisins et au fond des sillons, sont disposés chaque fois plusieurs transistors MOS, branchés en série, d'un dispositif de cellules de mémoire.

3. Procédé de fabrication d'un circuit intégré comportant au moins deux composants isolés l'un de l'autre,
- dans lequel on produit dans une surface (2) principale d'un substrat (1) semi-conducteur un sillon (3) qui comporte dans au moins un flanc dans la zone du fond du sillon une indentation (3'), la largeur du sillon étant plus grande dans la zone du fond du sillon que sur la surface (2) principale,
- dans lequel on produit sur le flanc ayant l'indentation (3') une structure (4', 5) d'isolement qui s'étend de la surface (2) principale jusqu'au fond du sillon et qui est plus épaisse dans la zone de l'indentation (3') que sur la surface principale,
- dans lequel on produit dans le substrat (1) semi-conducteur un premier composant et un deuxième composant, de telle manière qu'ils sont isolés l'un de l'autre par la structure (4', 5) d'isolement,
- dans lequel on produit le premier composant sur la surface (2) principale du substrat semi-conducteur et le deuxième composant au fond du sillon.

4. Procédé suivant la revendication 3,
dans lequel, pour produire le sillon (3), on effectue une opération d'attaque chimique à deux étapes d'attaque chimique, en effectuant une attaque chimique anisotrope lors de la première étape d'attaque chimique et une attaque chimique isotrope lors de la deuxième étape d'attaque chimique.

5. Procédé suivant la revendication 4,
dans lequel on réalise lors de la première étape d'attaque chimique un procédé d'attaque chimique assisté par plasma et lors de la deuxième étape d'attaque chimique un procédé d'attaque chimique isotrope assisté par plasma ou une attaque chimique isotrope par voie humide.

6. Procédé suivant l'une des revendications 3 à 5,
- dans lequel on produit le sillon (3) comme sillon longitudinal,
- dans lequel, pour former la structure (4', 5) d'isolement, on remplit le sillon (3) d'une première couche (4) isolante,
- dans lequel on effectue une attaque chimique en retour de la première couche (4) isolante par attaque chimique anisotrope sélective par rapport au substrat (1) semi-conducteur, en laissant subsister un résidu (4') d'attaque chimique, qui remplit sensiblement l'indentation (3'),
- dans lequel on produit au moins sur le flanc du sillon (3), en déposant une deuxième couche isolante à recouvrement de bord sensiblement conforme et en lui faisant subir une attaque chimique anisotrope en retour, un espaceur (5) isolant qui forme, conjointement avec le résidu (4') d'attaque chimique, la structure d'isolement.

7. Procédé suivant la revendication 6,
- dans lequel on produit plusieurs sillons (14) longitudinaux qui s'étendent sensiblement parallèlement, dont les flancs comportent dans la zone du fond du sillon des indentations (14') et dont les flancs sont munis chaque fois d'une structure (15, 17) d'isolement,
- dans lequel on forme sur la surface (12) principale, entre des sillons (14) longitudinaux voisins et au fond des sillons, chaque fois plusieurs transistors MOS, branchés en série, d'un dispositif de cellules de mémoire.
